# EUROPEAN PATENT APPLICATION

(11) **EP 2 657 717 A1**
(43) Date of publication of application: **30.10.2013**
(21) Application number: 12165627.6
(22) Date of filing: 26.04.2012
(51) Int. Cl.: G01R 33/561

(54) **Magnetic resonance imaging (MRI) radio frequency (RF) antenna array with Gysel power splitter**

(71) Applicant: Koninklijke Philips N.V., 5656 AE Eindhoven (NL); Philips Intellectual Property & Standards GmbH, 20099 Hamburg (DE)
(72) Inventor: Leussler, Christoph, 5600 AE Eindhoven (NL)
(74) Representative: Damen, Daniel Martijn

(57) **Abstract**

A magnetic resonance imaging (MRI) radio frequency (RF) antenna array (410), comprising
- a number of RF antennae (412), wherein the number is larger than two;
- at least one multi-way Gysel power splitter (416), wherein a number of ways is at least two;
wherein, in at least one state of operation, at least two RF antennae (412) of the number of RF antennae are connectable to the ways of the at least one multi-way Gysel power splitter (416) for providing RF power supplied by an RF amplifier (434, 436) to the at least two RF antennae (412), and wherein the at least one Gysel power splitter (416) is arranged on a carrier that is identical to a carrier of the at least two RF antennae (412) of the number of RF antennae (412).

## Description

### FIELD OF THE INVENTION

The invention pertains to a magnetic resonance imaging (MRI) radio frequency (RF) antenna array, an MRI RF antenna array system, and a method of operating an MRI system comprising an MRI RF antenna array system.

### BACKGROUND OF THE INVENTION

In the art of magnetic resonance imaging (MRI) it is known to make use of volume coils of TEM (transverse electromagnetic) wave or birdcage type for signal excitation in MRI systems. These volume coils are used as whole body coils at magnetic field strength of main magnets of the MRI system of 3 T or as head coil at 7 T, wherein each of these volume coils require an individual radio frequency (RF) drive to provide acceptable clinical image quality due to individual dielectric loading by a subject to be examined, usually a patient.

Conventional volume coils have a geometrically fixed two-port drive, in which the individual ports are driven by using a quadrature hybrid amplifier or by individual RF power amplifiers. RF power combination is either performed using Wilkinson combiners [1] or a network which consists of 90 degree-hybrid combiners [2, 3]. These networks have poor isolation between the individual ports or suffer from narrow bandwidth.

A conventional integrated volume coil may become redundant with an application of well-known local transmit/receive antenna arrays, provided that an RF power that is to be transmitted can be appropriately distributed among members of the antenna array. Due to varying dielectric loading generated by the patient and arising RF power reflection, a RF power splitter with a large isolation is required to omit using circulators, which are expensive and cannot be used locally at the local transmit/receive antenna array or on the MRI main magnet due to their contents of ferrite. Additionally, the poor isolation of the ports results in an unstable specific absorption rate (SAR) setting during an MRI scan.

### SUMMARY OF THE INVENTION

It is therefore an object of the invention to provide a magnetic resonance imaging (MRI) radio frequency (RF) antenna array with improved RF properties and particularly without any necessity for circulators.

In one aspect of the present invention, the object is achieved by a magnetic resonance imaging (MRI) radio frequency (RF) antenna array, comprising
- a number of RF antennae, wherein the number is larger than two;
- at least one multi-way Gysel power splitter, wherein a number of ways is at least two;
wherein, in at least one state of operation, at least two RF antenna of the number of RF antennae are connectable to the ways of the at least one multi-way Gysel power splitter for providing RF power to the at least two RF antennae, and wherein the at least one Gysel power splitter is arranged on a carrier that is identical to a carrier of the at least two RF antennae of the number of RF antennae.

The phrase "RF antenna", as used in this application, shall be understood particularly to encompass antennae that are provided to transmit RF electromagnetic fields, as well as antennae that are provided to transmit RF electromagnetic fields at one time of operation and to receive RF electromagnetic fields at another time of operation. RF antennae are preferably designed as a type of coil.

The invention exploits the well-known RF properties of a Gysel power splitter. Terminations in a Gysel power splitter are equal to a characteristic impedance Z₀ and can be high-power loads if a high power level is a requirement, such as in a transmitter. The loads can be external to a Gysel power splitter, as any length of Z₀ transmission line can be added between the loads and the Gysel splitter without changing the characteristic impedance Z₀. The concept of a Gysel power splitter may allow for improved control measurements of the circuitry which is beneficial for operating the magnetic resonance imaging (MRI) radio frequency (RF) antenna array. Moreover, a useable bandwidth of a Gysel power splitter can be larger than that of other known passive power splitters.

Thus, a magnetic resonance imaging (MRI) radio frequency (RF) antenna array can be provided with a high RF isolation and a potentially remote location of loads that can have a compact design at reduced costs.

In another aspect of the invention, at least one RF antenna of the number of RF antennae is designed as a local transmit/receive RF antenna. The phrase "transmit/receive antenna", as used in this application, shall be understood particularly as an antenna that is provided to transmit RF electromagnetic fields at one time of operation and to receive RF electromagnetic fields at another time of operation. By using at least one transmit/receive antenna, overall costs of the MRI RF antenna array can be further reduced and a compact design of the MRI RF antenna array can be attained.

In a preferred embodiment, the number of RF antennae is grouped into a number of groups of RF antennae, and the MRI RF antenna array further comprises a number of multi-way Gysel power splitters, wherein each group of RF antennae is connectable to at least one multi-way Gysel power splitter of the number of multi-way Gysel power splitters. The phrase "group of antennae", as used in this application, shall be understood particularly as a classification according to a relative location of the antennae to each other. A "group of antennae" may also encompass a group consisting of one RF antenna only. The phrase "connectable", as used in this application, shall be understood particularly as directly connected or indirectly connected, particularly via one or more of an impedance transformation network, a phase shifter, a directional coupler, a power probe (pick up coils, capacitive coupling) or a 90 degree quadrature hybrid combiner, to the least one multi-way Gysel power splitter. By that, the RF properties regarding a high RF isolation of the MRI RF antenna array can efficiently be improved without using any circulators and a compact design of the complete MRI RF antenna array can be achieved. The groups of RF antennae can be effectively combined by the Gysel RF power splitters.

In a preferred embodiment of the MRI RF antenna array, the number of groups of RF antennae equals the number of multi-way Gysel power splitters. Thereby, the high RF isolation of the MRI RF antenna array can be attained in a very cost-effective way.

In another aspect of the invention, at least one RF antenna of the number of RF antennae or at least one group of RF antennae of the groups of RF antennae is equipped with a mechanically flexible carrier. The phrase "mechanically flexible", as used in this application, shall be understood particularly as the property to be able to bend without breaking in case of an applied mechanical force. The bending may be either an elastic bending or an inelastic bending. As a result, a geometry of the at least one RF antenna of the number of RF antennae or at least one group of RF antennae of the groups of RF antennae can be adapted to a curvature of a patient's body for improving a signal-to-noise ratio. Preferably, the mechanically flexible carrier is a plastic film that is at least partially made from polyimide, such as Kapton^{®} (from DuPont), and/or from polyetherimide plastic materials.

In a further aspect of the invention, the at least one Gysel power splitter is at least partially designed as a stripline circuit or a microstrip circuit, which can result in a flat and small footprint that is easy to integrate, especially with RF antennae that are equipped with a mechanically flexible carrier, and is therefore cost-effective for production purposes. This is an improvement compared to, for instance, hybrid power splitters that require lumped components, such as capacitors.

It is another object of the invention to provide an MRI RF antenna array system, comprising at least one MRI RF antenna array of one of the embodiments or a combination of the embodiments described earlier, and at least one MRI RF amplifier for providing RF power to the at least one multi-way Gysel power splitter. The amplifier may one of any of the amplifier classes A, B, AB, C, D, W, etc. that the one of skills in the art is familiar with.

It is yet another object of the invention to provide a method of operating an MRI system comprising a main magnet and an MRI RF antenna array system, the method comprising the steps of
- generating RF power of at least two different frequencies, the one frequency to correspond to the Larmor frequency of hydrogen at a magnetic field strength of the main magnet, and the other frequency to correspond to the Larmor frequency of fluorine at the magnetic field strength of the main magnet;
- amplifying the generated RF power with the at least one MRI RF amplifier of the MRI RF antenna array system; and
- providing the amplified RF power of the at least two different frequencies to the at least one Gysel power splitter of the MRI RF antenna array.

By exploiting the comparatively large bandwidth of a Gysel power splitter, the method can enable the advantageous high RF isolation of an MRI RF antenna array in an operation of the MRI system in simultaneous fluorine/proton (F19/H1) applications.
[1] U. H. Gysel, "A new N-way power divider/combiner suitable for high-power application", IEEE MTT-S Int. Dig., May 1975, vol. 75, pp. 116-118
[2] D. Betancourt and C. del Rio Bocio, "A novel methodology to feed phased array antennas," IEEE Trans. Antennas Propag., no. 9, Sep. 2007, vol. 55, pp. 2489-2494
[3] S. S. Bharj, "A 1 kW Pulsed amplifier using MESFET, LDMOS and Bipolar transistors at 2856 MHz," IEEE Proc., 11th Annu. Wireless Microw. Technol. Conf. (WAMICON'10), Apr. 2010, pp. 1-3

### BRIEF DESCRIPTION OF THE DRAWINGS

These and other aspects of the invention will be apparent from and elucidated with reference to the embodiments described hereinafter. Such embodiment does not necessarily represent the full scope of the invention, however, and reference is made therefore to the claims and herein for interpreting the scope of the invention.

In the drawings:
Fig. 1 shows a schematic view of an MRI RF antenna array system of the prior art,
Fig. 2 illustrates a schematic view of the RF antennae of the MRI RF antenna array pursuant to Fig. 1 arranged around a patient,
Fig. 3 illustrates a scheme of a four-way Gysel power divider,
Fig. 4 illustrates a schematic view of an MRI RF antenna array system in accordance with the invention,
Fig. 5 illustrates another embodiment of an MRI RF antenna array system in accordance with the invention,
Fig. 6 depicts the embodiment of the MRI RF antenna array pursuant to Fig. 5 in detail,
Fig. 7a-d show several embodiments of alternative MRI RF antenna arrays in accordance with the invention, and
Fig.8 is a schematic view of another embodiment of an MRI RF antenna array system in accordance with the invention.

### DETAILED DESCRIPTION OF EMBODIMENTS

This description contains several embodiments of the invention. The individual embodiments are described with reference to particular groups of figures and are identified by a prefix number of the particular embodiment. Features the function of which is the same or basically the same in all embodiments are identified by reference numbers made up of the prefix number of the embodiment to which it relates, followed by the number of the feature.

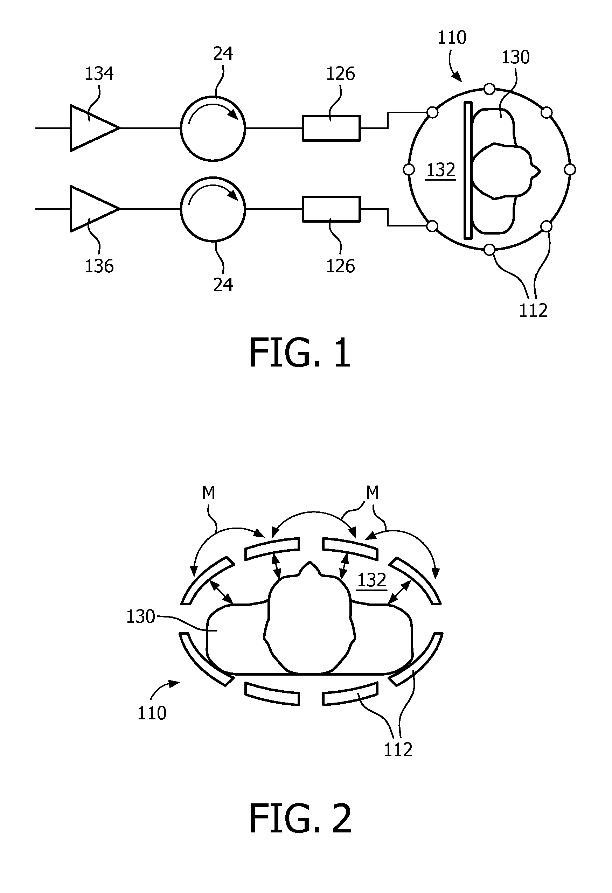

Fig. 1 shows a schematic view of a magnetic resonance imaging (MRI) radio frequency (RF) antenna array system of the prior art. The MRI RF antenna array system comprises two separate RF transmission channels, each of them conveying RF power of two different frequencies that correspond to the Larmor frequencies of hydrogen and fluorine, respectively, at a magnetic field strength of the main magnet of an MRI system (not shown in detail). The generated RF power is amplified by separate MRI RF amplifiers 134, 136 and fed via circulators 24 and transmit/receive switches 126 to an MRI RF antenna array 110 of eight transmit/receive RF antennae 112 that is arranged to surround a patient 130 lying in an examination region 132 of the MRI system. The transmit/receive switches 126 are controlled by a control unit (not shown) of the MRI system that is provided to control a timing of transmit and receive time periods as is known by the one of skills in the art. The circulators 24 provide a sufficient RF isolation between individual transmit/receive RF antennae 112. The downside of this prior art arrangement is that due to their contents of ferrite, circulators 24 are heavy, expensive and cannot be used in a vicinity of the MRI RF antenna array 110 or of the main magnet of the MRI system.

Fig. 2 illustrates a schematic view of the number of RF antennae 112 of the MRI RF antenna array 110 pursuant to Fig. 1, arranged around the patient 130 lying in the examination region 132 of the MRI system. For a practical flexible local RF transmit/receive antennae array 110, a location of the individual RF antennae 112 of the MRI RF antenna array 110 relative to a patient's tissue can change. Thus, RF antenna loading and induced losses differ with distance to the patient's tissue. RF power can be reflected to an input port and to the RF power amplifiers 134, 136. Due to a different location relative to an RF shield that is commonly present within the main magnet and to the bending of the RF antennae 112, mutual inductances M between RF antennae 112 is not constant and cross-coupling will unavoidably change an input impedance of the RF antennae 112. Thus, reflected power can be coupled and distributed to other RF antenna ports.

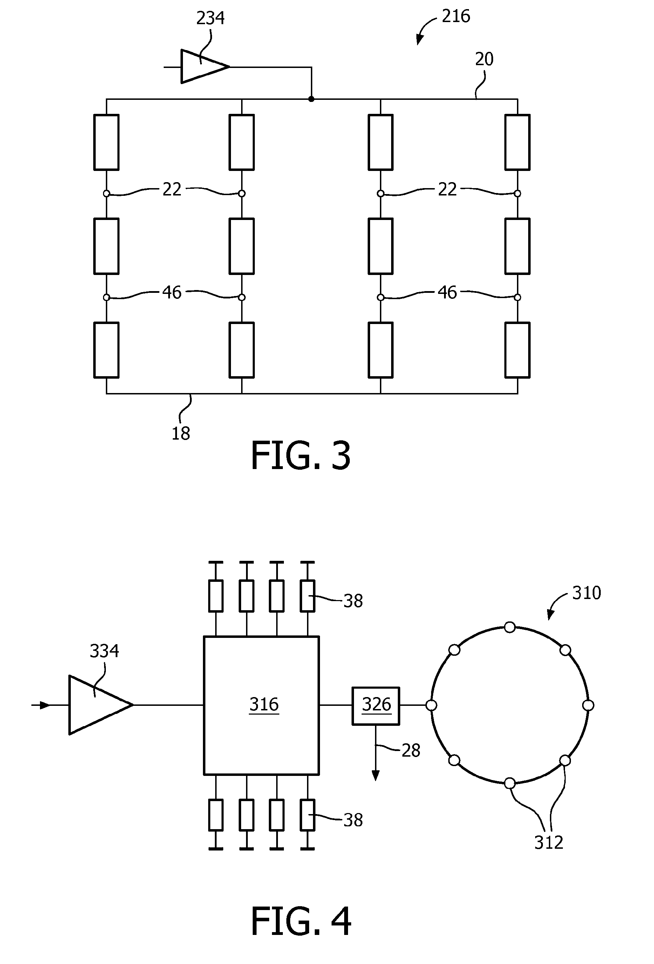

Fig. 3 illustrates a scheme of a four-way Gysel power splitter 216 that is equivalent to the one published in [1], comprising the well-known and advantageous RF properties described therein. The four-way Gysel power splitter 216 comprises a common input port 20, a common floating node 18 of the four ways, and load resistor terminals 46, and provides four terminals 22 with a high RF isolation to power four RF antennae.

Fig. 4 illustrates a schematic view of an MRI RF antenna array system in accordance with the invention. The MRI RF antenna array system comprises an MRI RF antenna array 310 with a number of RF antennae 312 wherein the number is eight, and the RF antennae 312 are designed as local transmit/receive RF antennae. Further, the MRI RF antenna array system comprises an MRI RF amplifier 334 for providing RF power to a multi-way Gysel power splitter 316 of the MRI RF antenna array 310 with eight ways, wherein each RF antenna 312 of the eight RF antennae 312 is connectable to one of the eight ways of the eight-way Gysel power splitter 316. In a state of operation, RF power is provided by the Gysel power splitter 316 to each of the RF antennae 312. A set of eight RF transmit/receive switches 326 is provided in the MRI RF antenna array system for controlling a timing of transmit and receive time periods and for transferring receive signals via receive signal lines 28. In Fig. 4, for the sake of clarity, the eight lines providing connections between the Gysel power splitter 316 and the array of eight RF antennae 312 via the set of eight RF transmit/receive switches 326 is shown symbolically as a single line only.

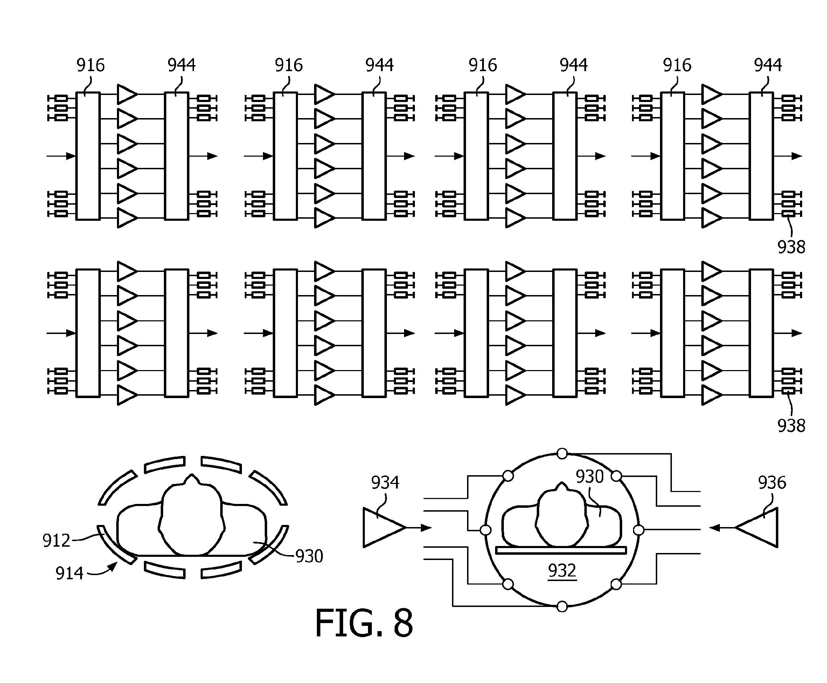

In general, it shall be understood that the local transmit/receive RF antennae in the embodiments described herein may be combined with one or a number of individual transmit coil members of a conventional body coil, wherein the local transmit/receive RF antennae and the transmit coil members of the conventional body coil may be connected to a Gysel power splitter or an RF circuitry, such as the one shown in Fig. 8, comprising a number of Gysel power splitters.

RF power that is reflected from each individual RF antenna 312 due to different loading is mostly dissipated in a load resistor 38 associated with the RF antenna 312. For the eight-way Gysel power splitter 316, an insertion loss between any one of output ports is 1.25 dB to load termination, 9.03 dB (1/8) to an input port and 17.5 dB to any other RF antenna input port.

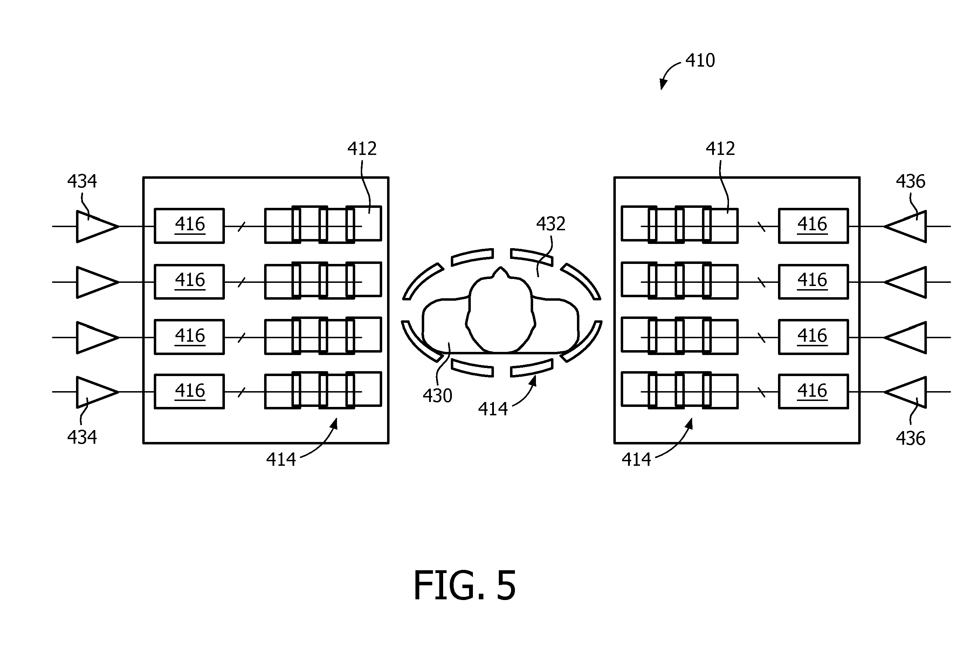

Fig. 5 illustrates another embodiment of an MRI RF antenna array system in accordance with the invention. The MRI RF antenna array system comprises an MRI RF antenna array 410 with a number of 32 RF antennae 412 designed as local transmit/receive RF antennae. The 32 RF antennae 412 are grouped in eight groups 414 of four RF antennae 412 each, wherein the RF antennae 412 of each group 414 are closely arranged. The MRI RF antenna array 410 further contains a number of four-way Gysel power splitters 416, wherein the number is eight. Each group 414 of four RF antennae 412 is connectable to one four-way Gysel power splitter 416 of the number of four-way Gysel power splitters 416, so that, in a state of operation, each RF antenna 412 of one of the groups 414 of four RF antennae 412 is powered by one way of the four ways of one of the Gysel power splitters 416. For reasons of simplicity, only a single line is shown in Fig. 5, symbolizing the four connecting lines between each of the Gysel power splitters 416 and a group 414 of four RF antennae 412.

In the embodiment illustrated in Fig. 5, the number of groups 414 of RF antennae 412 equals the number of multi-way Gysel power splitters 416. The MRI RF antenna array system further comprises eight RF amplifiers 434, 436 that are provided to each power one of the Gysel power splitters 416. The RF power provided by the eight RF amplifiers 434, 436 may have two different frequencies, one frequency corresponding to the Larmor frequency of hydrogen at a magnetic field strength of a main magnet of the MRI system, and the other frequency corresponding to the Larmor frequency of fluorine at the magnetic field strength of the main magnet of the MRI system.

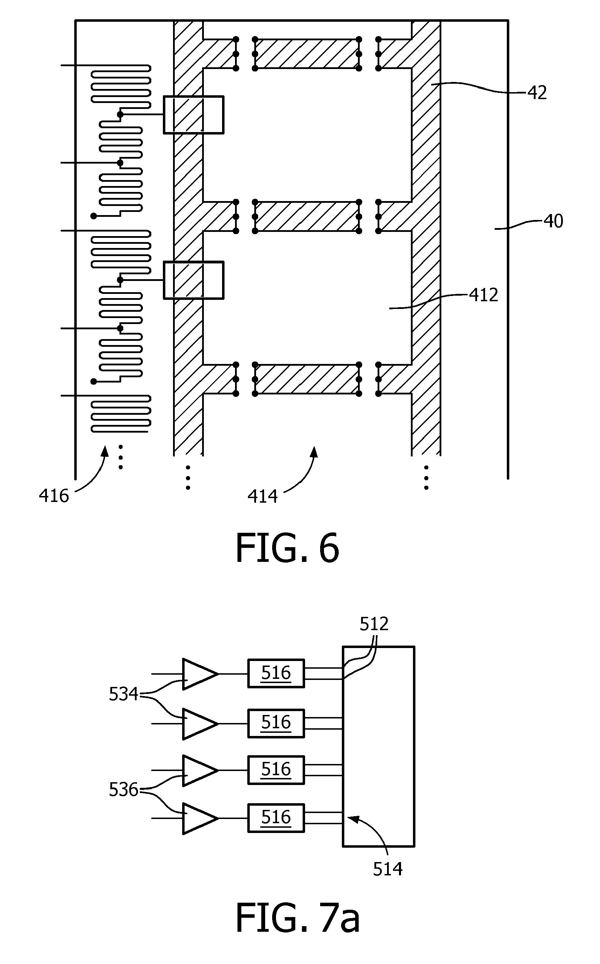

A middle part of Fig. 5 shows the eight groups 414 of four RF antennae 412 each, arranged to surround a patient 430 lying in an examination region 432 of an MRI system. The RF antennae 412 are each equipped with a mechanically flexible carrier 40 (Fig. 6) made from Kapton^{®} foil that allows for an adaptation of the RF antennae 412 to a curvature of the patient's body shape for improving a signal-to-noise ratio. Each of the Gysel power splitters 416 that provides RF power to one of the groups 414 of RF antennae 412 is arranged on a carrier that is identical to the mechanically flexible carrier 40 of the group 414 of RF antennae 412; i.e. the corresponding Kapton^{®} foil.

Fig. 6 depicts the embodiment of the MRI RF antenna array 410 pursuant to Fig. 5 in detail. The RF antennae 412 and the Gysel power splitters 416 are designed as stripline circuits, directly etched into a copper layer 42 on the Kapton^{®} foil. The individual power loads indicated in Fig. 4 and omitted in the illustration of Fig. 5, can be located remotely, thus reducing RF temperature heating in the RF antennae 412. The high RF isolation of the ways of the four-way Gysel power splitters 416 allows for a direct integration of one of the four-way Gysel power splitters 416 in close proximity to one of the RF antennae 412.

Fig. 7a-d show several embodiments of alternative MRI RF antenna arrays in accordance with the invention. In Fig. 7a, an MRI RF antenna array system comprises four RF amplifiers 534, 536, each provided for powering a separate two-way Gysel power splitter 516, output ports of which are each connected to one RF antenna 512 of a group 514 of two RF antennae 512, wherein each of the RF antennae 512 is designed as a local transmit/receive RF antenna.

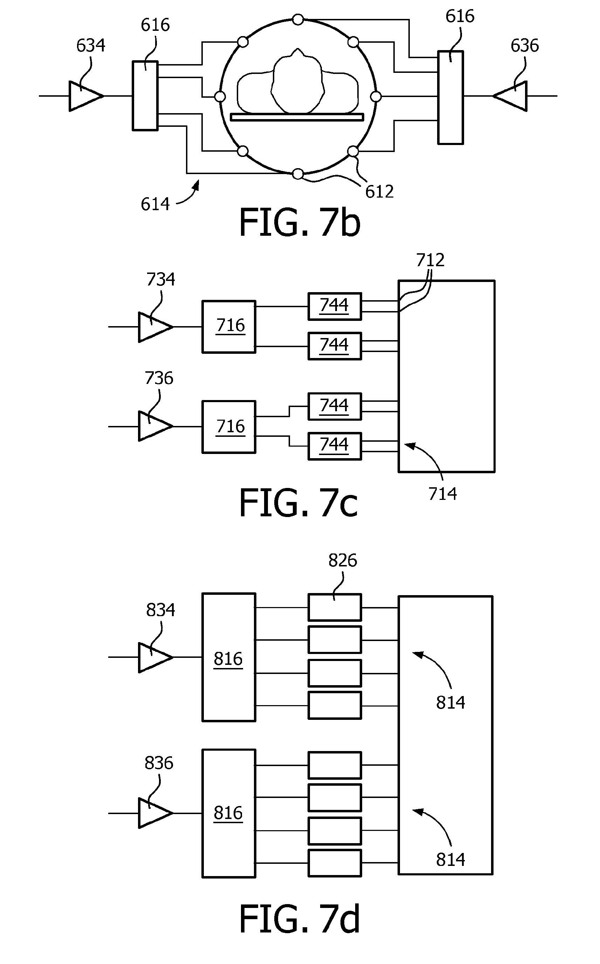

In Fig. 7b, an MRI RF antenna array system comprises two RF amplifiers 634, 636, each providing RF power of a different frequency, each frequency corresponding to a Larmor frequency of hydrogen and fluorine, respectively, at a magnet field strength of a main magnet of an MRI system. The RF amplifiers 634, 636 are each provided for powering a separate four-way Gysel power splitter 616, output ports of which are each connected to one RF antenna 612 of a group 614 of four RF antennae 612, wherein each of the RF antennae 612 is designed as a local transmit/receive RF antenna.

Fig. 7c shows an MRI RF antenna array system comprising two RF amplifiers 734, 736, each providing RF power of a different frequency, each frequency corresponding to a Larmor frequency of hydrogen and fluorine, respectively, at a magnet field strength of a main magnet of an MRI system. The RF amplifiers 734, 736 are each provided for powering a cascade of a two-way Gysel power splitter 716 and two two-way Gysel power splitters 744, output ports of which are each connected to one RF antenna 712 of a group 714 of two RF antennae 712, wherein each of the RF antennae 712 is designed as a local transmit/receive RF antenna.

Fig. 7d shows an MRI RF antenna array system that comprises two RF amplifiers 834, 836, each providing RF power of a different frequency, each frequency corresponding to a Larmor frequency of hydrogen and fluorine, respectively, at a magnet field strength of a main magnet of an MRI system. The RF amplifiers 834, 836 are each provided for powering a four-way Gysel power splitter 816, output ports of which are each connected via a transmit/receive switch 826 to one RF antenna 812 of a group 814 of four RF antennae 812, wherein each of the RF antennae 812 is designed as a local transmit/receive RF antenna. The transmit/receive switches 826 are controlled by a control unit (not shown) of the MRI system that is provided to control a timing of transmit and receive time periods.

Fig. 8 is a schematic view of another embodiment of an MRI RF antenna array system in accordance with the invention. The MRI RF antenna array system comprises eight RF amplifiers 934, 936 (only one RF amplifier symbolically shown for simplicity reasons), providing RF power of two different frequencies, each frequency corresponding to a Larmor frequency of hydrogen and fluorine, respectively, at a magnet field strength of a main magnet of an MRI system. The RF amplifiers 934, 936 are each provided for powering a six-way Gysel power splitter 916, output ports of which are each connected via a transmit/receive switch to one RF antenna 912 of a group 914 of six RF antennae 912, wherein each of the RF antennae 912 is designed as a local transmit/receive RF antenna, arranged to surround a patient 930 lying in an examination region 932 of an MRI system. Load resistors 938 are connected at a location that is remote to the RF antennae 912.

In case of a failure of an individual transistor stage of one of the RF amplifiers 934, 936, only minor output power degradation is observed, and a clinical MRI system does not have to stop an imaging procedure. Individual RF amplifiers 934, 936 can be exchanged during an MRI session of the MRI system due to a high RF isolation between individual RF ports of the Gysel power splitters 916. The eight-amplifier system is driven by eight individual digital transmit channels with RF pre-amplifiers. Alternatively, it may be driven by a dedicated hardware power splitter delivering fixed phases of the individual signals. Integrated transmit/receive switches and further drive electronics are not show in Fig. 8.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

### REFERENCE SYMBOL LIST

- 10: MRI RF antenna array
- 12: RF antenna
- 14: group (of antennae)
- 16: Gysel power splitter
- 18: floating node
- 20: input port
- 22: terminal
- 24: circulator
- 26: transmit/receive switch
- 28: receive signal line
- 30: patient
- 32: examination region
- 34: RF amplifier
- 36: RF amplifier
- 38: load resistor
- 40: flexible carrier
- 42: copper layer
- 44: Gysel power splitter
- 46: load resistor terminal
- M: mutual inductance

## Claims

1. A magnetic resonance imaging (MRI) radio frequency (RF) antenna array (10), comprising
- a number of RF antennae (12), wherein the number is larger than two;
- at least one multi-way Gysel power splitter (16, 44), wherein a number of ways is at least two;
wherein, in at least one state of operation, at least two RF antennae (12) of the number of RF antennae (12) are connectable to the ways of the at least one multi-way Gysel power splitter (16, 44) for providing RF power to the at least two RF antennae (12), and wherein the at least one Gysel power splitter 816) is arranged on a carrier (40) that is identical to a carrier (40) of the at least two RF antennae (12) of the number of RF antennae (12).

2. The MRI RF antenna array (10) as claimed in claim 1, wherein at least one RF antenna (12) of the number of RF antennae (12) is designed as a local transmit/receive antenna.

3. The MRI RF antenna array (10) as claimed in claim 1, the number of RF antennae (12) being grouped into a number of groups (14) of RF antennae (12), further comprising a number of multi-way Gysel power splitters (16, 44), wherein each group (14) of RF antennae (12) is connectable to at least one multi-way Gysel power splitter (16, 44) of the number of multi-way Gysel power splitters (16, 44).

4. The MRI RF antenna array (10) as claimed in claim 3, wherein the number of groups (14) of RF antennae (12) equals the number of multi-way Gysel power splitters (16, 44).

5. The MRI RF antenna array (10) as claimed in one of the preceding claims, wherein at least one RF antenna (12) of the number of RF antennae (12) or at least one group (14) of RF antennae (12) of the groups (14) of RF antennae (12) is equipped with a mechanically flexible carrier (40).

6. The MRI RF antenna array (10) as claimed in one of the preceding claims, wherein the at least one Gysel power splitter (16, 44) is at least partially designed as a stripline circuit or a microstrip circuit.

7. An MRI RF antenna array system, comprising:
- at least one MRI RF antenna array (10) as claimed in one of the preceding claims;
- at least one MRI RF amplifier (34, 36) for providing RF power to the at least one multi-way Gysel power splitter (16, 44).

8. A method of operating an MRI system comprising a main magnet and an MRI RF antenna array system as claimed in claim 7, comprising the following steps:
- generate RF power of at least two different frequencies, wherein the one frequency corresponds to the Larmor frequency of hydrogen at a magnetic field strength of the main magnet, and the other frequency correspond to the Larmor frequency of fluorine at the magnetic field strength of the main magnet;
- amplify the generated RF power with the at least one MRI RF amplifier (34, 36) of the MRI RF antenna array system; and
- provide the amplified RF power of the at least two different frequencies to the at least one Gysel power splitter (16, 44) of the MRI RF antenna array (10).
